# EUROPÄISCHE PATENTSCHRIFT

(11) **EP 1 302 990 B1**
(45) Veröffentlichungstag und Bekanntmachung des Hinweises auf die Patenterteilung: **16.12.2009**
(21) Anmeldenummer: 02019396.7
(22) Anmeldetag: 30.08.2002
(51) Int. Cl.: H01L 41/04

(54) **Verfahren zum Steuern eines Piezoantriebes und Piezoantrieb zur Durchführung des Verfahrens**
Control method for a piezoelectric actuator and corresponding actuator
Méthode de commande d'un actionneur piézoélectrique et actionneur correspondant

(30) Priorität: 09.10.2001 DE 10149671
(43) Veröffentlichungstag der Anmeldung: 16.04.2003
(73) Patentinhaber: EPPENDORF AG, 22339 Hamburg (DE)
(72) Erfinder: Jansen, Dirk, 22844 Norderstedt (DE); Baumgartner, Matthias, 22393 Hamburg (DE)
(74) Vertreter: Hauck Patent- und Rechtsanwälte

(56) Entgegenhaltungen:
- EP-A- 1 139 448
- WO-A-99/37400
- DE-A1- 3 522 994
- DE-A1- 4 011 277
- DE-A1- 10 027 013
- DE-A1- 19 644 521
- DE-A1- 19 845 042

## Beschreibung

Die Erfindung bezieht sich auf ein Verfahren zur Steuerung eines Piezoantriebes und auf einen zur Durchführung des Verfahrens geeigneten Piezoantrieb.

Piezoantriebe können auf verschiedenen Gebieten zur Anwendung kommen. Ein Anwendungsgebiet sind Dosiergeräte, insbesondere für kleine Dosiermengen im Nano- bis Milliliterbereich.

Die WO 99/10099 offenbart verschiedene Mikrodosiersysteme, die einen Freistrahldosierer und/oder eine Mikromembranpumpe aufweisen. Mikromembranpumpe bzw. Freistrahldosierer haben eine Verdrängerkammer und eine dieser zugeordnete, verformbare Verdrängerwand bzw. -membran, die von einem piezoelektrischen Aktor angetrieben werden kann. Die Verdrängerkammer ist mit einem Reservoir zum Versorgen mit Flüssigkeit verbunden und speist eine Dosieröffnung, die als Düse ausgebildet sein kann. Bei der Mikromembranpumpe läuft oder tropft die Flüssigkeit aus einer Dosieröffnung ab. Beim Freistrahldosierer wird hingegen die Flüssigkeit in einem Freistrahl aus der Dosieröffnung ausgestoßen. Aus dieser Druckschrift ist es bereits bekannt, ein Fluidmodul aus einem Reservoir und einer Verdrängerkammer in einen Aufnahmeschacht einer Dosiervorrichtung einzusetzen, die einen dem Aufnahmeschacht zugeordneten Aktor hat, der auf die Membran des Moduls einwirkt.

Aus der WO 99/37400 ist eine weitere Mikrodosiervorrichtung bekannt, die ein auswechselbar in einem Gehäuse angeordnetes Dosiermodul aufweist. Das Dosiermodul umfaßt einen Dosierchip mit Verdrängermembran und Druckkammer, die mit einer Düse und einem Mediumreservoir verbunden ist. Auch hier sind Aktor der Mikrodosiervorrichtung und der Verdränger des Dosiermoduls nicht fest miteinander verbunden. Vielmehr wird der Aktor lediglich in Kontakt mit dem Verdränger gebracht. Der Aktor ist ein Piezostapelaktor ("Piezostack"), dessen Kraft über einen drehbar gelagerten Hebellenker auf einen Druckpunkt der Dosierkammer übertragen wird. Das Dosiervolumen ist abhängig von der an den Piezostack angelegten Piezospannung. Bei einem weiteren Ausführungsbeispiel wird in einem als Ansaugphase bezeichneten Intervall ein Ansteuersignal U (t) mit einer geringen Flankensteilheit an die Betätigungsvorrichtung angelegt, was eine langsame Betätigung der Membran aus der Ausgangslage bewirkt. In einer Dosierphase wird das Ansteuersignal in einem sehr kurzen Intervall heruntergesteuert, um die Flüssigkeit durch die Düse in einem freien Strahl auszustoßen.

Bei der vorbekannten Spannungssteuerung ist nachteilig, daß die Genauigkeit der Auslenkung des Piezostacks nicht immer den Anforderungen entspricht.

Die EP 1 139 448 A1 offenbart ein Verfahren und eine Vorrichtung zum Steuern eines Piezoantriebes, bei dem/der der Strom beim Laden des Piezoelementes innerhalb eines Bandes mit einem Maximalwert und einem Minimalwert schwankt. Beim Entladen des Piezoelementes schwankt der Entladestrom innerhalb eines Bandes. Das Piezoelement wird durch Ein- und Ausschalten des Stromes geladen und entladen.

Die DE 35 22 994 A1 offenbart eine Steuerschaltung für ein Piezostellglied, bei der das Piezostellglied nach Maßgabe der Stellspannung eine Verformung erfährt. Am Piezostellglied wird ein Gegenkopplungssignal abgegriffen, das der Stellspannung entgegen auf einen als Regler dienenden Differenzialverstärker geführt wird. Als Regelabweichung liegt dann am Verstärkereingang die Signalspannung an. Der Aufladevorgang bzw. der Entladevorgang ist beendet, wenn die Regelabweichung Null ist, d. h. die am Piezostellglied anliegende Spannung bzw. das Gegenkopplungssignal der Stellspannung entspricht

Bei dieser Steuerschaltung nimmt der Ladestrom ausgehend von einem Maximalwerts an dem die am Verstärkereingang anliegende Regelabweichung maximal ist, bis auf den Wert Null ab, bei dem die Regelabweichung zu Null geworden is

Davon ausgehend liegt der Erfindung die Aufgabe zugrunde, ein Verfahren zum Steuern eines Piezoantriebes mit einer verbesserten Genauigkeit zur Verfügung zu stellen. Außerdem soll ein geeigneter Piezoantrieb zur Durchführung des Verfahrens zur Verfügung gestellt werden.

Die Aufgabe wird durch ein Verfahren mit den Merkmalen des Anspruches 1 gelöst. Ferner wird sie durch einen Piezoantrieb mit den Merkmalen des Anspruches 9 gelöst. Vorteilhafte Ausgestaltungen des Verfahrens und des Piezoantriebes sind in den Unteransprüchen angegeben.

Bei dem erfindungsgemäßen Verfahren zum Steuern eines Piezoantriebes wird
- für eine gewünschte Auslenkung eines Piezoaktors mit Hilfe der Auslenkungskennlinie des Piezoaktors eine an den Piezoaktor anzulegende Sollspannung ermittelt,
- der Piezoaktor mittels einer Stromquelle mit einem konstanten, eingeprägten Strom gespeist,
- die Spannung am Piezoaktor beim Speisen des Piezoaktors mit dem Strom aus der Stromquelle gemessen,
- die gemessene Spannung mit der Sollspannung verglichen und
- beim Erreichen der Sollspannung die Speisung des Piezoaktors mit dem Strom aus der Stromquelle abgeschaltet.

Ein Piezoantrieb, der geeignet zur Durchführung des Verfahrens ist, hat
- einen Piezoaktor,
- eine Einrichtung zum Ermitteln einer an den Piezoaktor anzulegenden Sollspannung für eine gewünschte Auslenkung des Piezoaktors,
- eine mit dem Piezoaktor verbundene Stromquelle zum Speisen des Piezoaktors mit einem konstanten, eingeprägten Strom,
- eine mit dem Piezoaktor verbundene Spannungsmeßeinrichtung zum Messen der Spannung am Piezoaktor,
- eine mit der Spannungsmeßeinrichtung und der Einrichtung zum Ermitteln einer Sollspannung verbundene Einrichtung zum Vergleichen der gemessenen Spannung und der Sollspannung und
- eine mit der Einrichtung zum Vergleichen und der Stromquelle verbundene elektrische Steuereinrichtung zum Abschalten der Speisung des Piezoaktors mit dem Strom der Stromquelle beim Erreichen der Sollspannung am Piezoaktor.

Analysen der vorbekannten Spannungssteuerung im Zusammenhang mit der vorliegenden Erfindung haben ergeben, daß sich eine vorgegebene Spannung erst allmählich am Piezostack einstellt, da dieser elektrisch einem Kondensator entspricht, so daß die Spannung entsprechend einer Exponentialfunktion ansteigt. Da nun aber die Auslenkung des Piezostacks proportional zur Spannung ist, wird die gewünschte Auslenkung erst mit einer gewissen Zeitverzögerung erreicht. Zudem ist die exponentielle Änderung der Auslenkung von einer sich stetig ändernden Dynamik begleitet. Als zusätzlicher unerwünschter Nebeneffekt stellt sich bei der Spannungssteuerung eine dielektrische Hysterese ein, wodurch es sehr schwierig wird, die Beziehung zwischen angelegter Spannung, Dynamik und Auslenkung zu ermitteln. Dem ist bei dem vorbekannten Ausführungsbeispiel mit dem Steuerflanken aufweisenden Ansteuersignal noch die zeitliche Änderung des Ansteuersignales überlagert.

Das erfindungsgemäße Verfahren und der Piezoantrieb arbeiten anstatt mit einer Spannungsquelle mit einer Stromquelle. Die Stromquelle zeichnet sich durch einen großen Innenwiderstand aus, so daß sie einen im wesentlichen konstanten Strom liefert. Der Innenwiderstand der idealen Stromquelle geht gegen Unendlich. Durch Laden bzw. Entladen des Piezoaktors mit einem konstanten eingeprägten Strom wird ein linearer Anstieg bzw. Abfall der Spannung am Piezoaktor erreicht, wodurch die Steigung bzw. Dynamik dieses Anstieges bzw. Abfalles abhängig von der treibenden Stromstärke ist. Untersuchungen im Zusammenhang mit der Erfindung haben auch gezeigt, daß bei dieser Art der Ansteuerung eine Hysterese des Weges vermieden bzw. minimiert wird.

Die einfachste Form, den Piezoaktor durch Stromsteuerung zu einer definierten Auslenkung zu zwingen, bestünde in einer zeitgesteuerten Stromquelle. Die Genauigkeit der Stromquelle und der Zeitsteuerung könnte mit relativ geringem Aufwand sichergestellt werden. Die sich über die Bestromungszeit einstellende Spannung und damit die Auslenkung des Piezoaktors ist jedoch auch eine Funktion der Kapazität des Piezostacks. Genauere Untersuchungen haben ergeben, daß sich dieser nicht wie ein idealer Kondensator verhält, sondern daß sich die Kapazität mit der Auslenkung des Piezoaktors ändert, wobei zwischen Kapazität und Auslenkung kein linearer Zusammenhang besteht. Außerdem würden Abhängigkeiten der Kapazität von Temperatur, Alterung und mechanischer Vorspannung am Piezoaktor zu Ungenauigkeiten bezüglich der Spannung und damit der Auslenkung führen.

Die Erfindung arbeitet deshalb mit einer den Piezoaktor speisenden Stromquelle und einer Messung der tatsächlich am Piezoaktor beim Speisen des Stroms anliegenden Spannung. Die gemessene Spannung wird mit der für das Erreichen der gewünschten Auslenkung erforderlichen Sollspannung verglichen, die mit Hilfe der Auslenkungskennlinie des Piezoaktors ermittelt werden kann, d.h. der Abhängigkeit der Auslenkung des Piezoaktors von der anliegenden Spannung. Sobald die gemessene Spannung der Sollspannung entspricht, wird die Speisung des Piezoaktors abgeschaltet und damit die gewünschte Auslenkung exakt erreicht. Auf diese Weise kann der Piezoaktor sowohl geladen als auch entladen werden, um den Piezoaktor auszudehnen oder zusammenzuziehen, d.h. in verschiedenen Richtungen auszulenken.

Eine nicht konstante Kapazität des Piezoaktors hat bei dieser Betriebsart nur noch einen geringen Einfluß auf die Dynamik der Auslenkung, aber nicht mehr auf die Auslenkung selbst. Die Genauigkeit der Auslenkung wird vor allem durch die Genauigkeit der Messung der Spannung am Piezoaktor bestimmt. Diese kann durch eine kalibrierte Spannungsmeßeinrichtung sichergestellt werden. Die Stromquelle kann hingegen grundsätzlich unabgeglichen betrieben werden und auch die Kapazität des Piezoaktors braucht grundsätzlich nicht berücksichtigt zu werden. Die Abhängigkeit von der toleranzbehafteten und im dynamischen Betrieb nicht konstanten Kapazität des Piezoaktors entfällt, ebenso die Abhängigkeit von der mechanischen Vorspannung, dem Alterszustand und der Temperatur. Die Genauigkeit der Auslenkung wird unter Erhalt der Genauigkeit der Auslenkung erheblich verbessert und der Aufwand für die Fertigung und den Service reduziert. Dies ist insbesondere für Anwendungen in Dosiergeräten von Vorteil.

Die Erfindung kann grundsätzlich bei beliebigen Piezoaktoren zur Anwendung kommen. Besonders vorteilhaft kommt sie bei Piezostacks zur Anwendung, weil bei Piezostacks die oben beschriebenen Kapazitätseinflüsse besonders ausgeprägt sind.

Es folgen Ausgestaltungen des Verfahrens:

Die Dynamik der Auslenkung hängt von dem Strom ab, mit dem der Piezoaktor gespeist wird. Nach einer Ausgestaltung ist die Stromquelle eine einstellbare Stromquelle, so daß durch Einstellen des Stromes die Dynamik der Auslenkung beeinflußbar ist. Durch die Einstellung der Stromquelle kann für die gesamte Auslenkung eine bestimmte Dynamik vorgegeben werden. Ferner kann auch durch Einstellen während der Auslenkung die Dynamik der Auslenkung beeinflußt werden.

Nach einer weiteren Ausgestaltung wird der Piezoaktor so gesteuert, daß das Ausdehnen und das Zusammenziehen mit unterschiedlicher Dynamik erfolgt. Dies kann insbesondere für die Verformung der Verdrängerwand von Verdrängerkammern in Dosiergeräten genutzt werden.

Nach einer Ausgestaltung wirkt der Piezoaktor auf eine verformbare Verdrängerwand einer Verdrängerkammer zum Dosieren von Fluiden ein und wird die Auslenkung des Piezoaktors für eine gewünschte Dosiermenge des Fluids mit Hilfe einer Dosiercharakteristik der Verdrängerkammer ermittelt und der Piezoaktor entsprechend gesteuert. Die Verdrängerkammer ist damit Bestandteil eines Piezoantriebs, der die Dosierung von Fluiden bewirkt. Die Dosiercharakteristik ist die Abhängigkeit des verdrängten Fluidvolumens von der Verformung der Verdrängerwand, die für die Verdrängerkammer ermittelbar ist.

Gemäß einer Ausgestaltung wird die gewünschte Dosiermenge mittels einer einzigen Auslenkung in die Verdrängerkammer aufgenommen und/oder aus dieser ausgestoßen. Dies kommt bei verhältnismäßig kleinen geringeren Dosiermengen zur Anwendung, die das Verdrängungsvolumen der Verdrängerkammer unterschreiten. Gemäß einer anderen Ausgestaltung wird die gewünschte Dosiermenge mittels mehrerer Auslenkungen in die Verdrängerkammer aufgenommen und/oder aus dieser ausgestoßen. Dies gilt insbesondere für verhältnismäßig große Dosiermengen, die das Verdrängungsvolumen der Verdrängerkammer übersteigen.

Wird die am Piezoaktor gemessene Spannung die Sollspannung nicht erreicht, wird auch die gewünschte Auslenkung nicht erzielt. Nach einer Ausgestaltung wird deshalb bei Nichterreichen der Sollspannung eine Fehlermeldung generiert.

Es folgen Ausgestaltungen des Piezoantriebs:

Nach einer Ausgestaltung ist mit dem Piezoaktor und der elektrischen Steuereinrichtung eine Stromquelle zum Laden und eine weitere Stromquelle zum Entladen verbunden, um ein Ausdehnen und Zusammenziehen des Piezoaktors zu steuern.

Die Spannungsmeßeinrichtung und die Einrichtung zum Vergleichen können verschiedene Einrichtungen sein. Nach einer Ausgestaltung ist die Einrichtung zum Ermitteln der Sollspannung mit einer Differenzspannungsmeßeinrichtung verbunden und ist die Differenzspannungsmeßeinrichtung mit der Steuereinrichtung verbunden, um den Strom abzuschalten, wenn die Differenzspannung aus Spannung und Sollspannung den Wert Null erreicht. Die Spannungsmeßeinrichtung und die Einrichtung zum Vergleichen fallen in der Differenzspannungsmeßeinrichtung zusammen.

Nach einer Ausgestaltung ist die Stromquelle und/oder die weitere Stromquelle mit einer elektrischen Spannungsversorgung verbunden, die mindestens eine Batterie und/oder mindestens einen Akku und/oder ein Netzteil umfaßt. Eine für den Betrieb des Piezoaktors erforderliche hohe Spannung wird nach einer weiteren Ausgestaltung durch einen Spannungswandler der elektrischen Spannungsversorgung erzeugt.

Die Speisung des elektrischen Stroms in den Piezoaktor kann auf verschiedene Weise eingeschaltet und abgeschaltet werden. Nach einer Ausgestaltung ist zwischen elektrischer Spannungsversorgung und der Stromquelle und/oder der weiteren Stromquelle eine elektrische Schalteinrichtung angeordnet, die mit der elektrischen Steuereinrichtung verbunden ist, um die Spannungsversorgung der Stromquelle und/oder der weiteren Stromquelle ein- und abzuschalten.

Nach einer Ausgestaltung umfaßt die elektrische Steuereinrichtung einen Mikrocomputer, d.h. arbeitet softwaregesteuert. Nach einer anderen Ausgestaltung ist die elektrische Steuereinrichtung eine Hardwaresteuerung.

Nach einer Ausgestaltung umfaßt der Piezoantrieb eine Verdrängerwand einer Verdrängerkammer zum Dosieren von Fluiden, um durch Verformen der Verdrängerwand Fluid in die Verdrängungskammer auszusaugen und/oder aus dieser einzustoßen. Die Verdrängerkammer ist dann Bestandteil des Piezoantriebes, der die Dosierung von Fluiden bewirkt. Die Verdrängerkammer und weitere Komponenten einer Mikrodosiervorrichtung können insbesondere wie in der WO 99/100999 und der WO 99/37400 beschrieben, ausgeführt sein. Die diesbezüglichen Angaben in vorstehenden Druckschriften werden durch Bezugnahme in diese Anmeldung einbezogen.

Nach einer weiteren Ausgestaltung sind Einrichtungen zum Eingeben einer Auslenkung des Piezoaktors und/oder einer Dosiermenge vorhanden.

Außer der Anwendung des Verfahrens und des Piezoantriebes in der Dosiertechnik sind vielfältige weitere Anwendungen möglich, bei denen es auf eine genaue Auslenkung des Piezoaktors ankommt, insbesondere bei Mikro-Verstellantrieben.

Weitere Einzelheiten und Vorteile der Erfindung ergeben sich aus der nachfolgenden Beschreibung der anliegenden Zeichnungen, die ein Ausführungsbeispiel zeigen. In den Zeichnungen zeigen:

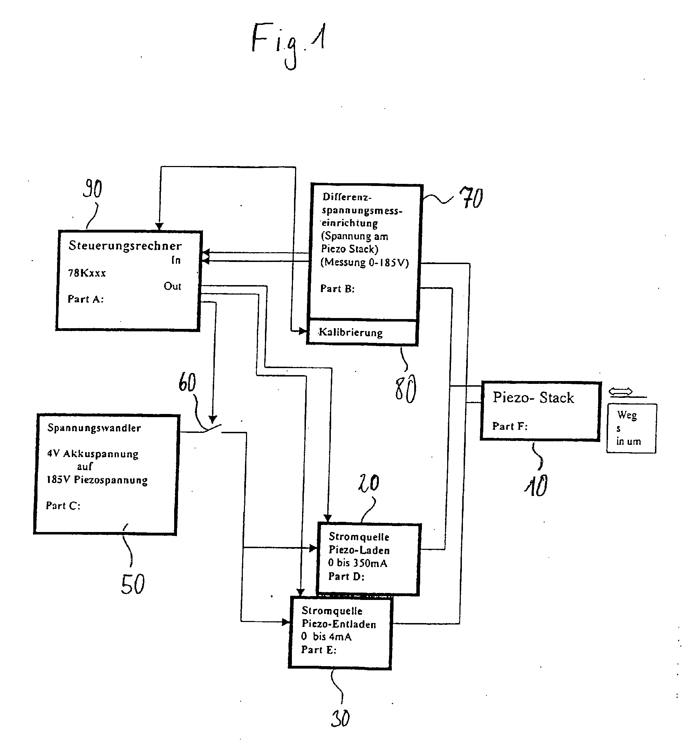

- Fig. 1: einen Piezoantrieb in einem grobschematischen Blockbild;
- Fig. 2: denselben Piezoantrieb in einem verfeinerten Blockschaltbild.

Der Piezoantrieb umfaßt einen Piezostack 10, der linear um einen Weg s ausdehnbar bzw. zusammenziehbar ist.

Ferner umfaßt er eine mit dem Piezostack 10 verbundene Stromquelle 20 zum Laden des Piezostacks. Die Stromquelle 20 hat einen einstellbaren Strom, im Beispiel zwischen 0 und 350 mA.

Des weiteren ist eine mit dem Piezostack 10 verbundene weitere Stromquelle 30 zum Endladen des Piezostacks 10 vorhanden. Die weitere Stromquelle ist beispielsweise im Bereich von 0 bis 4 mA einstellbar.

Zum Einstellen des Lade- bzw. Entladestromes sind die Stromquellen 20, 30 mit einem gemeinsamen Digital-Analog-Wandler 40 verbunden.

Die Stromquellen 20, 30 sind ferner mit einem Spannungswandler 50 verbunden, der eine Akkuspannung von 4 Volt in eine Piezospannung von 185 Volt umwandelt. Der Spannungswandler 50 kann als Trafowandler ausgeführt sein, der die Gleichspannung des Akkus mit ca. 100 kHz zerhackt, transformiert und gleichrichtet, um die Spannung von 185 Volt für den Piezostack 10 zur Verfügung zu stellen.

Der Spannungswandler 50 ist über eine elektrische Schalteinrichtung 60 mit den Stromquellen 20 und 30 verbunden.

Des weiteren ist eine Differenzspannungsmeßeinrichtung 70 vorhanden, der eine Kalibrierung 80 zugeordnet ist. Die Differenzspannungsmeßeinrichtung 70 ist ebenfalls mit dem Piezostack 10 verbunden. Sie umfaßt eine Präzisionskomparator 71 zum Detektieren einer oberen Endspannung einen weiteren Präzisionskomparator 72 zum Detektieren einer unteren Endspannung. Die Präzisionskomparatoren 71, 72 sind mit einem zweikanaligen Digital-Analog-Wandler 81 der Kalibrierung 80 verbunden, über den eine obere und eine untere Sollspannung vorgegeben werden kann. Der zweikanalige Digital-Analog-Wandler 81 ist hierzu mit einer Referenzspannungsquelle 82 verbunden.

Des weiteren sind die beiden Präzisionskomparatoren 71, 72 über eine Präzisions-Differenzverstärker 73 mit dem Piezostack 10 verbunden, wobei der Präzisions-Differenzverstärker 73 den Präzisionskomparatoren 71, 72 eine der Spannung am Piezostack 10 proportionale Spannung zuführt. Des weiteren ist ein Steuerungsrechner 90 vorhanden, wobei es sich im Beispiel um einen Mikrocontroller vom Typ NEC 78 Kxxx handelt. Der Steuerrechner 90 ist mit dem Digital-Analog-Wandler 40 der beiden Stromquellen 20, 30 verbunden, um die Lade- bzw. Entladeströme einzustellen.

Ferner ist der Steuerrechner 90 mit dem Spannungswandler 50 verbunden, um die Spannungswandlung zu steuern.

Des weiteren ist der Steuerrechner 90 mit der Schalteinrichtung 60 verbunden, um die Verbindung des Spannungswandlers 50 mit den Stromquellen 20, 30 zu öffnen und zu schließen.

Des weiteren ist der Steuerrechner 90 mit der Kalibrierung 80 verbunden, um die Vergleichsspannungen für die Präzisionskomparatoren 71, 72 einzustellen. Schließlich der Steuerrechner 90 mit der Differenzspannungsmeßeinrichtung 70 verbunden, um die von den Präzisionskomparatoren 71, 72 gelieferten Ausgangssignale aufzunehmen.

Der Piezoantrieb wird - beispielsweise in Verbindung mit einer Verdrängerkammer einer Mikrodosiervorrichtung - so betrieben, daß zunächst der Steuerrechner 90 über den Digital-Analogwandler 40 den Ladestrom der Stromquelle 20 und den Entladestrom der Stromquelle 30 je nach der gewünschten Dynamik einstellt. Des weiteren schließt die Steuereinrichtung 90 die Schalteinrichtung 60 und verbindet zunächst die Stromquelle 20 mit dem Piezostack 10.

Der Spannungsanstieg am Piezostack 10 wird über den Präzisions-Differenzverstärker 73 dem Präzisionskomparator 71 zugeführt, der die Spannung mit einer Sollspannung vergleicht, die ihm von der Steuereinrichtung 90 über den Digital-Analog-Wandler 81 vorgegeben wird. Bei Erreichen der Sollspannung erhält die Steuereinrichtung 90 ein Signal, das das Erreichen der gewünschten Auslenkung anzeigt und einen Interrupt auslöst.

Aufgrund des Interrupts schaltet die Steuereinrichtung 90 die Stromquelle 20 ab und die Stromquelle 30 ein, um von der Ladephase auf die Entladephase umzuschalten. Der von der Steuereinrichtung 90 über den Digital-Analog-Wandler 81 mit einer Sollspannung versorgte Präzisionskomparator 72 löst beim Erreichen der ihm vorgegebenen Sollspannung bei der Steuereinrichtung 90 einen weiteren Interrupt aus, der das Ende des Ablaufs signalisiert. Dann hat sich der Piezostack 10 um das gewünschte Ausmaß zusammengezogen und die Stromquelle 30 wird mittels der Schalteinrichtung 60 abgeschaltet.

Die Spannungsmeßeinrichtung 70 wird während der Fertigung einmalig abgeglichen (Offsetkompensation des Differenzverstärkers 73) und anschließend ist nach Kompensation der Reaktionszeiten der Steuereinrichtung 90 ein Betrieb von beliebigen Piezostacks 10 ähnlicher elektrischer Werte ohne weitere Einzelkalibrierung möglich.

Ein Vorteil dieser Betriebsweise besteht darin, daß eine genaue Bestimmung der elektrischen Daten des Piezostacks 10 nicht notwendig ist und Veränderungen durch Alterung, Temperatur etc. automatisch ausgeglichen werden. Die Genauigkeit der Stromquellen 20, 30 spielt nur noch eine untergeordnete Rolle. Ungenauigkeiten wirken sich nur noch in leichter Veränderung des dynamischen Verhaltens aus, aber dies in so geringer Weise, daß hier keine Veränderung des Dosierverhaltens zu erwarten ist.

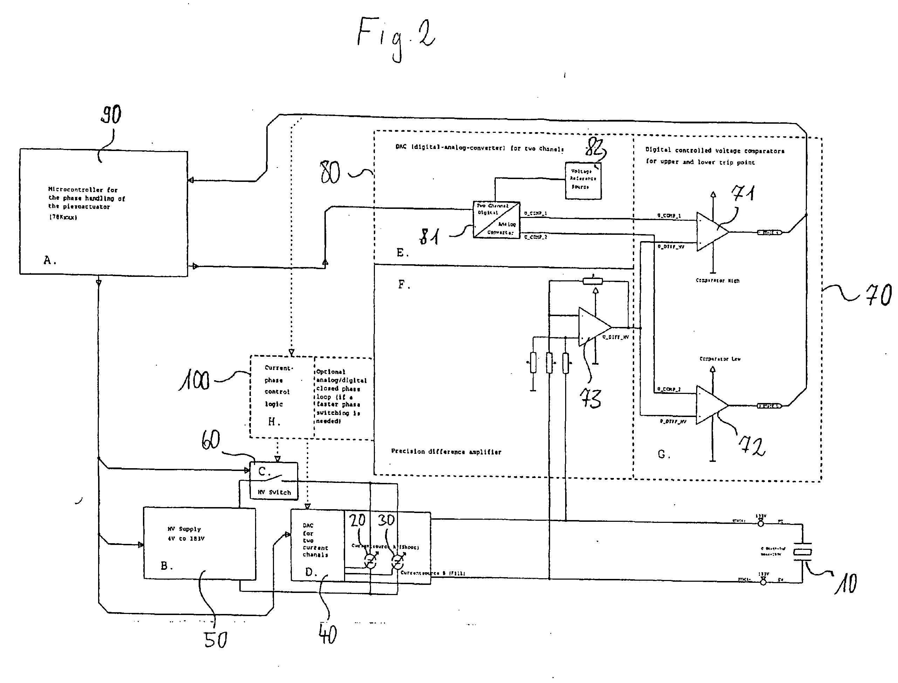

In die Fig. 2 ist zusätzlich ein Beispiel für eine Hardwaresteuerung dargestellt. Diese umfaßt eine Zustandsmaschine 100, die über den Digital-Analog-Wandler 40 die Stromquellen 20, 30 und die die elektrische Schalteinrichtung 60 steuert. Der Zustandsmaschine 100 werden die Ausgangssignale der Präzisionskomparatoren 71, 72 zugeführt. Die Zustandsmaschine 100 kann eine digital oder analog gesteuerte Zustandsmaschine sein. In diesem Beispiel dient die Steuereinrichtung 90 lediglich der Steuerung der Kalibrierung 80 und des Spannungswandlers 50. Auch diese Funktionen können von einer Hardware übernommen werden. Der Strom- und Spannungsverlauf am Piezostack 10 ist derselbe wie der bei dem oben beschriebenen Ausführungsbeispiel ohne Zustandsmaschine 100, bei dem die Komponenten 20, 30, 40, 60 ebenfalls von der softwaregesteuerten Steuereinrichtung 90 gesteuert werden.

## Patentansprüche

1. Verfahren zum Steuern eines Piezoantriebes, bei dem
- für eine gewünschte Auslenkung eines Piezoaktors (10) mit Hilfe der Auslenkungskennlinie des Piezoaktors (10) eine an den Piezoaktor (10) anzulegende Sollspannung ermittelt wird,
- der Piezoaktor (10) mittels einer Stromquelle (20, 30) mit einem konstanten eingeprägten Strom gespeist wird,
- die Spannung am Piezoaktor (10) beim Speisen des Piezoaktors (10) mit dem Strom aus der Stromquelle (20, 30) gemessen wird,
- die gemessene Spannung mit der Sollspannung verglichen wird und
- beim Erreichen der Sollspannung die Speisung des Piezoaktors (10) mit dem Strom aus der Stromquelle (20, 30) abgeschaltet wird.

2. Verfahren nach Anspruch 1, bei dem die Stromquelle (20, 30) einstellbar ist.

3. Verfahren nach Anspruch 1 oder 2, bei dem der Piezoaktor (10) so gesteuert wird, daß ein Ausdehnen und ein Zusammenziehen des Piezoaktors (10) mit unterschiedlicher Dynamik erfolgt.

4. Verfahren nach einem der Ansprüche 1 bis 3, bei dem der Piezoaktor (10) auf eine verformbare Verdrängerwand einer Verdrängerkammer zum Dosieren von Fluiden einwirkt und die Auslenkung des Piezoaktors (10) für eine gewünschte Dosiermenge des Fluids mit Hilfe einer Dosiercharakteristik der Verdrängerkammer ermittelt und der Piezoaktor entsprechend gesteuert wird.

5. Verfahren nach Anspruch 4, bei dem eine gewünschte Dosiermenge mittels einer einzigen Auslenkung in die Verdrängerkammer aufgenommen und/oder aus dieser ausgestoßen wird.

6. Verfahren nach Anspruch 4 oder 5, bei dem die gewünschte Dosiermenge mittels mehrerer Auslenkungen in die Verdrängerkammer aufgenommen und/oder aus dieser ausgestoßen wird.

7. Verfahren nach einem der Ansprüche 1 bis 6, bei dem bei Nichterreichen der Sollspannung eine Fehlermeldung generiert wird.

8. Verfahren nach einem der Ansprüche 1 bis 7, bei dem ein Piezoantrieb mit einem Piezostack gesteuert wird.

9. Piezoantrieb, geeignet zur Durchführung des Verfahrens nach einem der Ansprüche 1 bis 8, mit
- einem Piezoaktor (10),
- einer Einrichtung zum Ermitteln (80) einer an den Piezoaktor (10) anzulegenden Sollspannung für eine gewünschte Auslenkung des Piezoaktors (10),
- einer mit dem Piezoaktor (10) verbundenen Stromquelle (20, 30) zum Speisen des Piezoaktors (10) mit einem konstanten eingeprägten Strom,
- einer mit dem Piezoaktor (10) verbundenen Spannungsmeßeinrichtung (70) zum Messen der Spannung am Piezoaktor (10),
- einer mit der Spannungsmeßeinrichtung (70) und der Einrichtung zum Ermitteln einer Sollspannung verbundenen Einrichtung zum Vergleichen (70) der gemessenen Spannung und der Sollspannung und
- einer mit der Einrichtung zum Vergleichen (70) und der Stromquelle (20, 30) verbundenen elektrischen Steuereinrichtung (90) zum Abschalten der Speisung des Piezoaktors (10) mit dem Strom der Stromquelle (20, 30) beim Erreichen der Sollspannung am Piezoaktor (10).

10. Piezoantrieb nach Anspruch 9, bei dem mit dem Piezoaktor (10) und der elektrischen Steuereinrichtung (90) eine Stromquelle (20) zum Laden des Piezoaktors (10) und eine weitere Stromquelle (30) zum Entladen des Piezoaktors (10) verbunden ist.

11. Piezoantrieb gemäß Anspruch 10, bei dem die Einrichtung zum Ermitteln (80) der Sollspannung mit einer Differenzspannungsmeßeinrichtung (70) verbunden ist und die Differenzspannungsmeßeinrichtung (70) mit der Steuereinrichtung (90) verbunden ist, um den Strom abzuschalten, wenn die Differenzspannung aus Spannung und Sollspannung den Wert Null erreicht.

12. Piezoantrieb nach einem der Ansprüche 9 bis 11, bei dem die Stromquelle (20) und/oder die weitere Stromquelle (30) mit einer elektrischen Spannungsversorgung (50) verbunden ist, die mindestens eine Batterie und/oder mindestens einen Akku und/oder ein Netzteil umfaßt.

13. Piezoantrieb nach Anspruch 12, bei dem die elektrische Spannungsversorgung (50) einen Spannungswandler umfaßt.

14. Piezoantrieb nach Anspruch 12 oder 13, bei dem zwischen der elektrischen Spannungsversorgung (50) und der Stromquelle (20) und/oder der weiteren Stromquelle (30) eine elektrische Schalteinrichtung (60) angeordnet ist, die mit der elektrischen Steuereinrichtung (90) verbunden ist, um die Spannungsversorgung der Stromquelle (20) und/oder der weiteren Stromquelle (30) ein- und abzuschalten.

15. Piezoantrieb nach einem der Ansprüche 9 bis 14, bei dem die elektrische Steuereinrichtung (90) einen Mikrocomputer umfaßt.

16. Piezoantrieb gemäß einem der Ansprüche 9 bis 14, bei dem die elektrische Steuereinrichtung (90) eine Hardwaresteuerung (100) umfaßt.

17. Piezoantrieb nach einem der Ansprüche 9 bis 16, bei dem der Piezoaktor (10) ein Piezostack ist.

18. Piezoantrieb nach einem der Ansprüche 9 bis 17, der eine verformbare Verdrängerwand einer Verdrängerkammer zum Dosieren von Fluiden umfaßt, um durch Verformen der Verdrängerwand Fluid aus der Verdrängerkammer auszustoßen und/oder in diese einzusaugen.

19. Piezoantrieb nach einem der Ansprüche 9 bis 18, der Einrichtungen zum Eingeben einer Auslenkung des Piezoaktors (10) und/oder einer Dosiermenge umfaßt.

## Claims

1. A method for controlling a piezoelectric drive wherein:
- a required voltage to be applied to a piezoactuator (10) for a desired deflection of the piezoactuator (10) is determined by means of the deflection characteristic curve of the piezoactuator (10),
- the piezoactuator (10) is supplied with an impressed constant current by means of a current source (20, 30),
- the voltage is measured on the piezoactuator (10) while the piezoactuator (10) is being supplied with the current from the current source (20, 30),
- the voltage measured is compared to the voltage required, and
- the supply of the piezoactuator (10) with the current from the current source (20, 30) is turned off once the required voltage is reached.

2. The method as claimed in claim 1 wherein the current source (20, 30) is adjustable.

3. The method as claimed in claim 1 or 2 wherein the piezoactuator (10) is controlled so as to effect expansion and contraction of the piezoactuator (10) at different dynamics.

4. The method as claimed in any one of claims 1 to 3 wherein the piezoactuator (10) acts on a deformable displacement wall of a displacement chamber for proportioning fluids and the deflection of the piezoactuator (10) for a desired proportioning volume of the fluid is determined by means of a proportioning characteristic curve of the displacement chamber and the piezoactuator (10) is controlled accordingly.

5. The method as claimed in claim 4 wherein a desired proportioning volume is received in and/or expelled from the displacement chamber by means of a single deflection.

6. The method as claimed in claim 4 or 5 wherein the desired proportioning volume is received in and/or expelled from the displacement chamber by means of several deflections.

7. The method as claimed in any one of claims 1 to 6 wherein an error message is generated if the required voltage is not reached.

8. The method as claimed in any one of claims 1 to 7 wherein a piezoelectric drive is controlled by a piezostack.

9. A piezoelectric drive suitable for implementing the method as claimed in any one of claims 1 to 8, comprising:
- a piezoactuator (10),
- a device for determining (80) a required voltage to be applied to the piezoactuator (10) for a desired deflection of the piezoactuator (10),
- a current source (20, 30) connected to the piezoactuator (10) for supplying the piezoactuator (10) with an impressed constant current,
- a voltage measuring device (70) connected to the piezoactuator (10) for measuring the voltage on the piezoactuator (10),
- a device connected to the voltage measuring device (70) and the device for determining a required voltage to compare (70) the voltage measured and the voltage required, and
- an electric control device (90) connected to the device for comparing (70) and the current source (20, 30) to turn off the supply of the piezoactuator (10) with the current of the current source voltage (20, 30) once the required voltage is reached.

10. The piezoelectric drive as claimed in claim 9 wherein the piezoactuator (10) and the electric control device (90) have connected thereto a current source (20) for charging the piezoactuator (10) and a further current source (30) for discharging the piezoactuator (10).

11. The piezoelectric drive as claimed in claim 10 wherein the device for determining (80) the required voltage is connected to a differential voltage measuring device (70) and the differential voltage measuring device (70) is connected to the control device (90) in order to switch the current off if the differential voltage from the voltage and the required voltage reaches the zero value.

12. The piezoelectric drive as claimed in any one of claims 9 to 11 wherein the current source (20) and/or the other current source (30) are connected to an electric voltage supply (50) which comprises at least one battery and/or at least one accumulator and/or a power supply unit.

13. The piezoelectric drive as claimed in claim 12 wherein the electric voltage supply (50) comprises a voltage converter.

14. The piezoelectric drive as claimed in claim 12 or 13 wherein an electric switching mechanism (60) is disposed between the electric voltage supply (50) and the current source (20) and/or the further current source (30) and is connected to the electric control device (90) in order to switch on and off the voltage supply of the current source (20) and/or the further current source (30).

15. The piezoelectric drive as claimed in any one of claims 9 to 14 wherein the electric control device (90) comprises a microcomputer.

16. The piezoelectric drive as claimed in any one of claims 9 to 14 wherein the electric control device (90) comprises a hardware control unit (100).

17. The piezoelectric drive as claimed in any one of claims 9 to 16 wherein the piezoactuator (10) is a piezostack.

18. The piezoelectric drive as claimed in any one of claims 9 to 17 which comprises a deformable displacement wall of a displacement chamber for proportioning liquids in order to expel a fluid from/draw a fluid into the displacement chamber by deforming the displacement wall.

19. The piezoelectric drive as claimed in any one of claims 9 to 18 which comprises devices for inputting a deflection of the piezoactuator (10) and/or a proportioning volume.

## Revendications

1. Méthode pour commander un actionneur piézoélectrique, dans laquelle
pour un débattement souhaité d'un actuateur piézoélectrique (10), une tension électrique exigée qu'il faut appliquer à l'actuateur piézoélectrique (10) est déterminée avec l'aide de la courbe caractéristique du débattement de l'actuateur piézoélectrique (10),
l'actuateur piézoélectrique (10) est alimenté avec un courant électrique constant et indépendant de la charge par une source de courant (20, 30),
la tension dans l'actuateur piézoélectrique (10) est mesurée lorsque l'actuateur piézoélectrique (10) est alimenté par le courant de la source de courant (20, 30),
la tension mesurée est comparée avec la tension exigée, et
l'alimentation de l'actuateur piézoélectrique (10) avec le courant de la source de courant (20, 30) est arrêtée quand la tension exigée est atteinte.

2. Méthode selon la revendication 1, dans laquelle la source de courant (20, 30) est ajustable.

3. Méthode selon la revendication 1 ou 2, dans laquelle l'actuateur piézoélectrique (10) est commandé tellement que une expansion et une contraction de l'actuateur piézoélectrique (10) se passent avec des dynamiques différentes.

4. Méthode selon l'une quelconque des revendications 1 à 3, dans laquelle l'actuateur piézoélectrique (10) agit sur une paroi à déplacement déformable d'une chambre de déplacement volumétrique pour doser des fluides, et le débattement de l'actuateur piézoélectrique (10) pour une quantité souhaitée de dosage du fluide est déterminé avec l'aide d'une courbe caractéristique de dosage de la chambre de déplacement volumétrique, et l'actuateur piézoélectrique est commandé de façon correspondante.

5. Méthode selon la revendication 4, dans laquelle la quantité souhaitée de dosage est reçue dans la chambre de déplacement volumétrique et/ou éjectée en dehors de celle-ci par un seul débattement.

6. Méthode selon la revendication ou 4 ou 5, dans laquelle la quantité souhaitée de dosage est reçue dans la chambre de déplacement volumétrique et/ou éjectée de celle-ci par plusieurs débattements.

7. Méthode selon l'une quelconque des revendications 1 à 6, dans laquelle un message d'erreur est généré quand la tension exigée n'est pas achevée.

8. Méthode avec un courant constant de selon l'une quelconque des revendications 1 à 7, dans laquelle un actionneur piézoélectrique est commandé par des piles piézoélectriques.

9. Actionneur piézoélectrique, approprié pour l'exécution de la méthode selon l'une quelconque des revendications 1 à 8, avec
un actuateur piézoélectrique (10),
un dispositif pour la détermination (80) d'une tension exigée qu'il faut appliquer à l'actuateur piézoélectrique (10) pour un débattement souhaité de l'actuateur piézoélectrique (10),
une source de courant (20, 30) connectée à l'actuateur piézoélectrique (10) pour alimenter l'actuateur piézoélectrique (10) avec un courant constant et indépendant de la charge,
un dispositif (70) pour mesurer la tension, pour mesurer la tension chez l'actuateur piézoélectrique (10) et qui est connecté à l'actuateur piézoélectrique (10),
un dispositif pour la comparaison (70) de la tension mesurée et de la tension exigée qui est connecté au dispositif (70) pour mesurer la tension et au dispositif pour la détermination d'une tension exigée, et
un dispositif électrique de commande (90) qui est connecté au dispositif (70) pour la comparaison et à la source de courant (20, 30) afin d'arrêter l'alimentation de l'actuateur piézoélectrique (10) avec le courant de la source de courant (20, 30) quand la tension exigée est atteinte chez l'actuateur piézoélectrique (10).

10. Actionneur piézoélectrique selon la revendication 9, dans lequel une source de courant (20) pour charger l'actuateur piézoélectrique (10) et une autre source de courant (30) pour décharger l'actuateur piézoélectrique (10) sont connectées avec l'actuateur piézoélectrique (10) et le dispositif électrique de commande (90).

11. Actionneur piézoélectrique selon la revendication 10, dans lequel le dispositif pour la détermination (80) de la tension exigée est connecté avec un dispositif pour mesurer la différence de tension (70), et le dispositif pour mesurer la différence de tension (70) est connecté au dispositif de commande (90) afin de couper le courant quand la différence de tension entre la tension et la tension exigée a atteint la valeur de zéro.

12. Actionneur piézoélectrique selon l'une quelconque des revendications 9 à 11, dans lequel la source de tension (20) et/ou l'autre source de tension (30) est connectée à un dispositif d'alimentation en énergie électrique (50) qui comporte au moins une batterie et/ou au moins un accumulateur et/ou un bloc de courant

13. Actionneur piézoélectrique selon la revendication 12, dans lequel le dispositif d'alimentation en énergie électrique (50) comporte un transformateur de tension.

14. Actionneur piézoélectrique selon la revendication 12 ou 13, dans lequel un dispositif électrique de commutation (60) est disposé entre le dispositif d'alimentation en énergie électrique (50) et la source de tension (20) et/ou l'autre source de tension (30), ledit dispositif électrique de commutation (60) étant connecté au dispositif électrique de commande (90) afin d'activer ou désactiver l'alimentation avec courant de la source de tension (20) et/ou l'autre source de tension (30).

15. Actionneur piézoélectrique selon la revendication 9 à 14, dans lequel le dispositif électrique de commande (90) comporte un mini-ordinateur.

16. Actionneur piézoélectrique selon la revendication 9 à 14, dans lequel le dispositif électrique de commande (90) comporte un dispositif de commande à hardware (100).

17. Actionneur piézoélectrique selon la revendication 9 à 16, dans lequel l'actuateur piézoélectrique (10) sont des piles piézoélectriques.

18. Actionneur piézoélectrique selon la revendication 9 à 17, qui comporte une paroi à déplacement déformable d'une chambre de déplacement volumétrique pour doser des fluides, afin d'éjecter du fluide en dehors de la chambre de déplacement volumétrique et/ou pour aspirer de fluide vers celle-ci en déformant la paroi à déplacement.

19. Actionneur piézoélectrique selon la revendication 9 à 18, qui comporte des dispositifs pour introduire un débattement de l'actuateur piézoélectrique (10) et/ou d'une quantité de dosage.
